# EUROPEAN PATENT APPLICATION

(11) **EP 3 389 122 A1**
(43) Date of publication of application: **17.10.2018**
(21) Application number: 17196591.6
(22) Date of filing: 16.10.2017
(51) Int. Cl.: H01M 4/66, C23C 14/20, C23C 14/56

(54) **CATHODE CURRENT COLLECTOR, METHOD OF PREPARING THE CATHODE CURRENT COLLECTOR, AND BATTERY WITH THE CATHODE CURRENT COLLECTOR**

(30) Priority: 14.04.2017 CN 201710243658; 26.07.2017 CN 201710619524
(71) Applicant: Shenzhen Xinzhimei Technology Co., Ltd., Shenzhen, Guangdong (CN)
(72) Inventor: HONG LI, Qiu, Shenzhen, Guangdong (CN)
(74) Representative: Becker Kurig Straus

(57) **Abstract**

A cathode current collector includes a plastic film, an adhesive strength enhancement layer, a copper metal layer, and an antioxidant layer. The plastic film includes an upper surface and a lower surface. Each of the upper surface and the lower surface of the plastic film is sequentially plated with the adhesive strength enhancement layer, the copper metal layer, and the antioxidant layer. The copper metal layer is plated between the adhesive strength enhancement layer and the antioxidant layer. A method of preparing the cathode current collector and a battery comprising the cathode current collector are also provided.

## Description

### FIELD

The subject matter herein generally relates to a current collector, a method of preparing the current collector, and a battery with the current collector.

### BACKGROUND

A cathode current collector of a traditional lithium-ion battery comprises copper foil. A surface of the copper foil needs to be performed anti-oxidation. And a traditional anti-oxidation method easily leads to the fall-off of the copper plating.

### BRIEF DESCRIPTION OF THE DRAWINGS

Implementations of the present disclosure will now be described, by way of example only, with reference to the attached figures.
FIG. 1 is a structure diagram of one exemplary embodiment of a cathode current collector with a multi-layer structure.
FIG 2 is a flowchart of a first exemplary embodiment of a method of preparing the cathode current collector.
FIG. 3 is a flowchart of a second exemplary embodiment of the method of preparing the cathode current collector.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, components have not been described in detail so as not to obscure the related relevant feature being described. Also, the description is not to be considered as limiting the scope of the embodiments described herein. The drawings are not necessarily to scale and the proportions of certain parts may be exaggerated to better illustrate details and features of the present disclosure.

The term "comprising," when utilized, means "including, but not necessarily limited to"; it specifically indicates open-ended inclusion or membership in the so-described combination, group, series, and the like.

The present disclosure is described in relation to cathode current collector, a method of preparing the cathode current collector, and a battery with the cathode current collector.

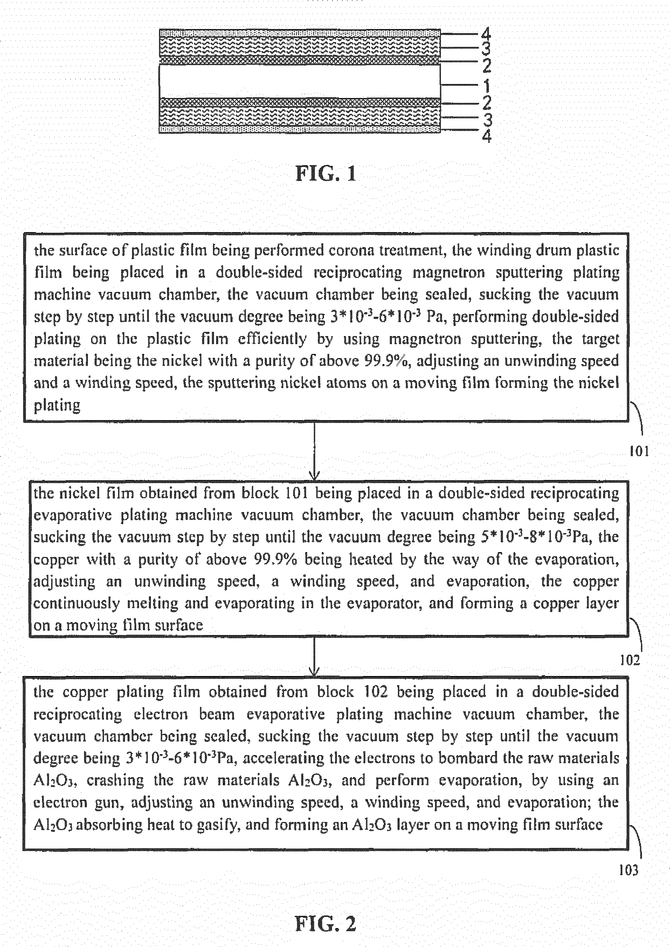

FIG. 1 illustrates a cathode current collector with a multi-layer structure. The cathode current collector comprises a plastic film I, an adhesive strength enhancement layer 2, a copper metal layer 3, and an antioxidant layer 4. The plastic film I comprises an upper surface (not labeled) and a lower surface (not labeled). Each of the upper surface and the lower surface of the plastic film 1 is sequentially plated with the adhesive strength enhancement layer 2, the copper metal layer 3, and the antioxidant layer 4. The copper metal layer 3 is plated between the adhesive strength enhancement layer 2 and the antioxidant layer 4.

A plastic film layer is used to reduce weight. Compared with a traditional copper foil current collector, the copper plating film current collector can reduce 70% of weight and significantly improve the battery energy density. In at least one exemplary embodiment, the plastic film 1 is an oriented polypropylene (OPP), or a polyimide (PI), or a polyethylene terephthalate (PET), or a cast polypropylene (CPP), or a polyvinylchlorid (PVC). Preferably, the plastic film is the PET, or the PI, or the CPP. In at least one exemplary embodiment, a thickness of the plastic film 1 is 2-12 micrometers (µm). Preferably, the thickness of the plastic film 1 is 4-8 µm. The resistant temperature of the plastic film is 120-300 degrees Celsius (°C).

Plating an adhesive strength enhancement layer 2 can reduce the fall-off of the copper metal layer 3 and prevent the performance of the copper metal layer 3 being lost. Preferably, the adhesive strength enhancement layer 2 is metal plating or non-metal plating. If the adhesive strength enhancement layer 2 is the metal plating, the metal is nickel (Ni) or nickel alloy, and the nickel alloy is nickel-cuprum (NiCu) alloy, nickel-chromium (NiCr) alloy, or nickel-vanadium (NiV) alloy. Calculated as a percentage by mass, when the nickel alloy is the NiCu alloy, the NiCu alloy is consisted of 60%-80% of Ni and 20%-40% of Cu. Preferably, the nickel alloy is consisted of the 60% of Ni and the 40% of Cu, or the 70% of Ni and 30% of Cu, or the 80% of Ni and 20% of Cu. When the nickel alloy is the NiCr alloy, the NiCr alloy is consisted of 10%-30% of Ni and 70%-90% of Cr. Preferably, NiCr alloy is consisted of the 10% of Ni and 90% of Cr, or the 20% of Ni and 80% of Cr, or the 30% of Ni and 70% of Cr. When the nickel alloy is the NiV alloy, the NiV alloy is consisted of 80%-95% of Ni and 5%-20% of V. Preferably, the NiV alloy is consisted of the 91% ofNi and 9% of V, or the 93% ofNi and 7% of V, or the 95% of Ni and 5% of V.

Preferably, the adhesive strength enhancement layer 2 uses the nickel alloy metal plating, because during the process of lithium battery being used, the electrolyte is chemically reacted to generate hydrogen fluoride (HF), and the effect of the nickel alloy is that a weight loss of the lithium battery is about 0, as the storage time goes on. However, when the adhesive strength enhancement layer uses the Ni alloy metal plating, a weight loss of the lithium battery is about 20% within 1500 hours, as the storage time goes on.

When the adhesive strength enhancement layer 2 is the non-metal plating, the non-metal is SiC, Si₃N₄, or Al₂O₃. Preferably, the non-metal is Al₂O₃. The bonding performance between the Ni and the plastic film 1 is nice. The bonding performance between the Ni and the copper metal layer 3 is nice. The bonding performance between the Al₂O₃ and the plastic film t is nice. The bonding performance between the Al₂O₃ and the copper metal layer 3 is nice. Thus the copper plating more difficultly falls off. A thickness of the adhesive strength enhancement layer 2 is 10-100 nanometers (nm). Preferably, the thickness of the adhesive strength enhancement layer 2 is 10-50 nm.

A thickness of the copper metal layer 3 is 100-1000 nm. Preferably, the thickness of the copper metal layer is 200-600 nm. Replacing the copper foil current collector of the original lithium battery with the copper plastic film current collector, the copper plating layer is reduced to less than 1 µm from 6 µm of the traditional pure copper foil, the amount of the copper greatly reduces, and the cost of the current collector can be reduced by above 50%.

The function of the antioxidant layer 4 is to prevent the copper metal layer from being oxidized. The antioxidant layer 4 can be the dense metal layer or non-metal layer. When the antioxidant layer 4 is the metal layer, the metal is Ni or nickel alloy, and the nickel alloy may be the NiCu alloy, the NiCr alloy, or the NiV alloy. Calculated as a percentage by mass, when the nickel alloy is the NiCu alloy, the NiCu alloy is consisted of 60%-80% of Ni and 20%-40% of Cu. Preferably, the NiCu alloy is consisted of the 60% of Ni and 40% of Cu, or the 70% of Ni and 30% of Cu, or the 80% of Ni and 20% of Cu. When the nickel alloy is the NiCr alloy, the NiCr alloy is consisted of 10%-30% ofNi and 70%-90% of Cr. Preferably, the NiCr alloy is consisted of the 10% of Ni and 90% of Cr, or the 20% of Ni and 80°30 of Cr, or the 30% of Ni and 70% of Cr. When the nickel alloy is the NiV alloy, the NiV alloy is consisted of 80%-95% ofNi and 5%-20% of V. Preferably, the NiV alloy is consisted of the 91% ofNi and 9% of V, or the 93% of Ni and 7% of V, or the 95% of Ni and 5% of V.

Like the adhesive strength enhancement layer 2, preferably, the antioxidant layer 4 also uses the nickel alloy metal plating, because during the process of the lithium battery being used, the electrolyte is chemically reacted to generate the HF, and the effect of the nickel alloy is that a weight loss of the lithium battery is about 0, as the storage time goes on. Each of the adhesive strength enhancement layer 2 and the antioxidant layer 4 uses the nickel alloy plating to guarantee the effect. However, when the adhesive strength enhancement layer 2 uses the Ni alloy metal plating, a weight loss of the lithium battery is about 20% within 1500 hours, as the storage time goes on.

When the antioxidant layer 4 is the non-metal layer, the non-metal is Al₂O₃, Si₃N₄, or SiC. Preferably, the non-metal is the Al₂O₃. When the antioxidant layer 4 is formed by a way of using the plating film, the falling-off problem of the copper layer of the plastics can be solved, while the purpose of anti-oxidation can be realized. A thickness of the antioxidant layer 4 is 10-100nm. Preferably, the thickness of the antioxidant layer 4 is 10-50nm.

FIG. 2 illustrates a flowchart of a method in accordance with a first example embodiment. A method of preparing the cathode current collector is provided by way of example, as there are a variety of ways to carry out the method. The method of preparing the cathode current collector described below can be carried out using the configurations illustrated in FIG. 1, for example, and various elements of these figures are referenced in explaining method of preparing the cathode current collector. The illustrated order of blocks is by example only and the order of the blocks can change. Additional blocks may be added or fewer blocks may be utilized without departing from this disclosure, The method of preparing the cathode current collector can begin at block 101.

At block 101, the surface of plastic film being performed corona treatment, the winding drum plastic film being placed in a double-sided reciprocating magnetron sputtering plating machine vacuum chamber, the vacuum chamber being sealed, sucking the vacuum step by step until the vacuum degree being 3*10⁻³-6*10⁻³ Pa, performing double-sided plating on the plastic film efficiently by using magnetron sputtering, the target material being the nickel with a purity of above 99.9%, adjusting an unwinding speed and a winding speed, the sputtering nickel atoms on a moving film forming the nickel plating. Thus the adhesive strength enhancement layer is formed.

At block 102, the nickel film obtained from block 101 being placed in a double-sided reciprocating evaporative plating machine vacuum chamber, the vacuum chamber being sealed, sucking the vacuum step by step until the vacuum degree being 5*10⁻³*10⁻³Pa, the copper with a purity of above 99.9% being heated by the way of the evaporation, adjusting an unwinding speed, a winding speed, and evaporation, the copper continuously melting and evaporating in the evaporator, and forming a copper layer on a moving film surface. Thus the copper metal layer is formed.

At block 103, the copper plating film obtained from block 102 being placed in a double-sided reciprocating electron beam evaporative plating machine vacuum chamber, the vacuum chamber being sealed, sucking the vacuum step by step until the vacuum degree being 3*10⁻³-6*10⁻³Pa, accelerating the electrons to bombard the raw materials Al₂O₃, crash the raw materials Al₂O₃, and perform evaporation, by using an electron gun, adjusting an unwinding speed, a winding speed, and evaporation. Al₂O₃ absorbs heat to gasify, and forming an Al₂O₃ layer on a moving film surface. Thus the antioxidant layer is formed.

Thus, the cathode current collector with a multi-layer structure is formed.

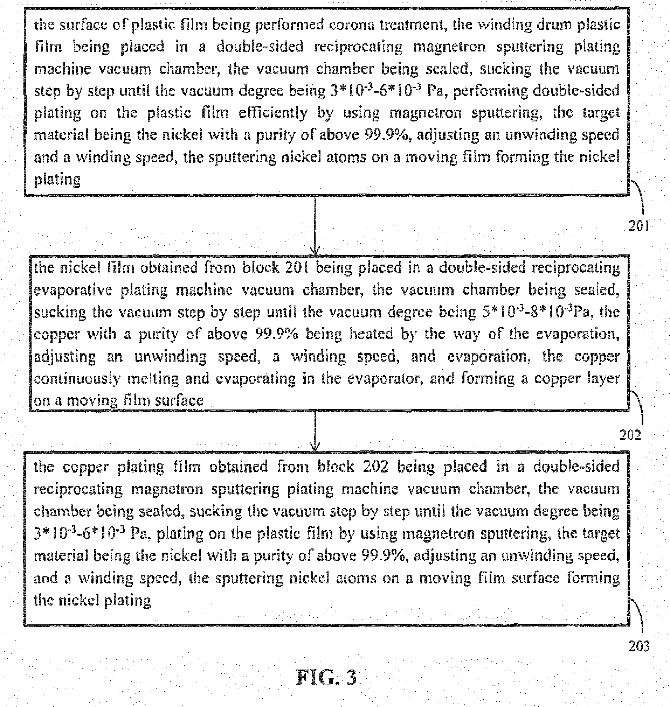

FIG. 3 illustrates a flowchart of a method in accordance with a second example embodiment. The method of preparing the cathode current collector is provided by way of example, as there are a variety of ways to carry out the method. The method of preparing the cathode current collector described below can be carried out using the configurations illustrated in FIG. 1, for example, and various elements of these figures are referenced in explaining method of preparing the cathode current collector. The illustrated order of blocks is by example only and the order of the blocks can change. Additional blocks may be added or fewer blocks may be utilized without departing from this disclosure. The method of preparing the cathode current collector can begin at block 201.

At block 201, the surface of plastic film being performed corona treatment, the winding drum plastic film being placed in a double-sided reciprocating magnetron sputtering plating machine vacuum chamber, the vacuum chamber being sealed, sucking the vacuum step by step until the vacuum degree being 3*10⁻³-6*10⁻³ Pa, performing double-sided plating on the plastic film efficiently by using magnetron sputtering, the target material being the nickel with a purity of above 99.9%, adjusting an unwinding speed and a winding speed, the sputtering nickel atoms on a moving film forming the nickel plating. Thus the adhesive strength enhancement layer is formed.

At block 202, the nickel film obtained from block 201 being placed in a double-sided reciprocating evaporative plating machine vacuum chamber, sucking the vacuum step by step until the vacuum degree being 5*10⁻³-8-10⁻³Pa, the copper with a purity of above 99.9% being heated by the way of the evaporation, adjusting an unwinding speed, a winding speed, and evaporation, the copper continuously melting and evaporating in the evaporator, and forming a copper layer on a moving film surface. Thus the copper metal layer is formed.

At block 203, the copper plating film obtained from block 202 being placed in a double-sided reciprocating magnetron sputtering plating machine vacuum chamber, the vacuum chamber being sealed, sucking the vacuum step by step until the vacuum degree being 3*10⁻³-6*10⁻³ Pa, plating on the plastic film by using magnetron sputtering, the target material being the nickel with a purity of above 99.9%, adjusting an unwinding speed, and a winding speed, the sputtering nickel atoms on a moving film surface forming the nickel plating. Thus the antioxidant layer is formed.

Thus, the cathode current collector with a multi-layer structure is formed.

The cathode current collector obtained from each of the first and second exemplary embodiments is used to the lithium-ion battery, the most basic function is to collect current, and also as carrier to be used to store cathode electrode materials, the cathode electrode materials (battery active substance) generate current and collect the generated current to form large current, thus the large current can be externally output.

The cathode current collector obtained from each of the first and second exemplary embodiments is used to be test, the test results can be the conclusions as follows:
the plastic film layer is used to reduce weight. Specifically, compared with the traditional copper foil current collector, the copper plating film current collector can reduce 70% of weight to significantly improve energy density;
the plastic film has a stronger tensile strength as a substrate, thus the windows in the preparation process, such as the widows of the tension, and the widows of pressure, will be bigger, thus the material can be used to achieve greater pressure to achieve greater pressure density, thereby enabling to improve the process manufacturing capacity;
plating an adhesive strength enhancement layer can reduce the fall-off the copper metal layer, to prevent the performance of the copper metal layer being lost;
using the new copper current collector to replace the copper foil current collector of the original lithium battery, the copper plating layer is reduced to less than 1 µm from 6 µm of the traditional pure copper foil, the amount of the copper greatly reduces, and the cost of the current collector can be reduced by more than 50%; and
the antioxidant layer is formed by the way of using the plating film, the fall-off problem of the copper layer of the plastics can be solved, while the purpose of anti-oxidation can be realized.

The exemplary embodiments shown and described above are only examples. Many details are often found in the art such as the other features of a cathode current collector, a method of preparing the cathode current collector, and a battery with the cathode current collector. Therefore, many such details are neither shown nor described. Even though numerous characteristics and advantages of the present technology have been set forth in the foregoing description, together with details of the structure and function of the present disclosure, the disclosure is illustrative only, and changes may be made in the detail, including in matters of shape, size, and arrangement of the parts within the principles of the present disclosure, up to and including the full extent established by the broad general meaning of the terms used in the claims. It will therefore be appreciated that the exemplary embodiments described above may be modified within the scope of the claims.

## Claims

1. A cathode current collector with a multi-layer structure, comprising:
a plastic film (1) comprising:
an upper surface; and
a lower surface;
an adhesive strength enhancement layer (2);
a copper metal layer (3); and
an antioxidant layer (4);
wherein each of the upper surface and the lower surface of the plastic film (1) is sequentially plated with the adhesive strength enhancement layer (2), the copper metal layer (3), and the antioxidant layer (4);
wherein the copper metal layer (3) is plated between the adhesive strength enhancement layer (2) and the antioxidant layer (4).

2. The cathode current collector of claim 1, wherein the plastic film (1) can be is an oriented polypropylene, OPP, or a polyimide, PI, or a polyethylene terephtalate, PET, or a cast polypropylene, CPP, or a polyvinylchloride, PVC.

3. The cathode current collector of claim 1, wherein a thickness of the plastic film (1) is 2-12 micrometers, µm.

4. The cathode current collector of claim 1, wherein the adhesive strength enhancement layer (2) is a metal plating film or a non-metal plating film; when the adhesive strength enhancement layer (2) is the metal plating film, the metal is Ni or nickel alloy; when the adhesive strength enhancement layer (2) is the non-metal plating film, the non-metal is SiC, or Si₂N₄, or Al₂O₃.

5. The cathode current collector of claim 4, wherein the nickel alloy is nickel-cuprum, NiCu, alloy, nickel-chromium, NiCr, alloy, or nickel-vanadium, NiV, alloy; calculated as a percentage by mass, when the nickel alloy is the NiCu alloy, the NiCu alloy is consisted of 60%-80% of Ni and 20%-40% of Cu; when the nickel alloy is the NiCr alloy, the NiCr alloy is consisted of 10%-30% of Ni and 70%-90% of Cr; and when the nickel alloy is the NiV alloy, the NiV alloy is consisted of 80%-95% of Ni and 5%-20% of V.

6. The cathode current collector of claim 1, wherein a thickness of the adhesive strength enhancement layer (2) is 10-100 nanometers, nm.

7. The cathode current collector of claim 1, wherein a thickness of the copper metal layer (3) is 100-1000 nm.

8. The cathode current collector of claim 1, wherein the antioxidant layer (4) is a dense metal layer or non-metal layer; when the antioxidant layer (4) is the metal layer, the metal is Ni or nickel alloy; and when the antioxidant layer (4) is the non-metal layer, the non-metal is Al₂O₃, Si₃N₄, or SiC.

9. The cathode current collector of claim 8, wherein the nickel alloy is NiCu alloy, NiCr alloy, or NiV alloy; calculated as a percentage by mass, when the nickel alloy is the NiCu alloy, the NiCu alloy is consisted of 60%-80% of Ni and 20%-40% of Cu; when the nickel alloy is the NiCr alloy, the NiCr alloy is consisted of 10%-30% ofNi and 70%-90% of Cr; and when the nickel alloy is the NiV alloy, the NiV alloy is consisted of 80%-95% of Ni and 5%-20% of V.

10. The cathode current collector of claim 1, wherein a thickness of the antioxidant layer (4) is 10-100 nm.

11. A method of preparing the cathode current collector of claim 1, comprising:
block 101, the surface of plastic flm (1) being performed corona treatment, the winding drum plastic film being placed in a double-sided reciprocating magnetron sputtering plating machine vacuum chamber, the vacuum chamber being scaled, sucking the vacuum step by step until the vacuum degree being 3*10⁻³-6*10⁻³ Pa, performing double-sided plating on the plastic film efficiently by using magnetron sputtering, the target material being the nickel with a purity of above 99.9%, adjusting an unwinding speed and a winding speed, the sputtering nickel atoms on a moving film forming the nickel plating; thus the adhesive strength enhancement layer (2) being formed;
block 102, the nickel film obtained from block 101 being placed in a double-sided reciprocating evaporative plating machine vacuum chamber, the vacuum chamber being sealed, sucking the vacuum step by step until the vacuum degree being 5*10⁻³-8*10⁻³Pa, the copper with a purity of above 99.9% being heated by the way of the evaporation, adjusting an unwinding speed, a winding speed, and evaporation, the copper continuously melting and evaporating in the evaporator, and forming a copper layer on a moving film surface; thus the copper metal layer (3) being formed;
block 103, the copper plating film obtained from block 102 being placed in a double-sided reciprocating electron beam evaporative plating machine vacuum chamber, the vacuum chamber being sealed, sucking the vacuum step by step until the vacuum degree being 3*10⁻³-6*10⁻³Pa, accelerating the electrons to bombard the raw materials Al₂O₃, crash the raw materials Al₂O₃, and perform evaporation, by using an electron gun, adjusting an unwinding speed, a winding speed, and evaporation; the Al₂O₃ absorbing heat to gasify, and forming an Al₂O₃ layer on a moving film surface; thus the antioxidant layer (4) being formed; and
block 203, the copper plating film obtained from block 102 being placed in the double-sided reciprocating magnetron sputtering plating machine vacuum chamber, the vacuum chamber being sealed, sucking the vacuum step by step until the vacuum degree being 3*10⁻³-6*10⁻³ Pa, plating on the plastic film by using magnetron sputtering, the target material being the nickel with a purity of above 99.9%, adjusting an unwinding speed, and a winding speed, the sputtering nickel atoms on a moving film surface forming the nickel plating; thus the antioxidant layer (4) being formed;
wherein either of block 103 or block 203 is performed after block 102.

12. A battery comprises the cathode current collector in one of claims 1-10.
